# EUROPEAN PATENT SPECIFICATION

(11) **EP 0 729 186 B1**
(45) Date of publication and mention of the grant of the patent: **06.05.1999**
(21) Application number: 95830055.0
(22) Date of filing: 24.02.1995
(51) Int. Cl.: H01L 29/78, H01L 29/739, H01L 29/423

(54) **MOS-technology power device integrated structure and manufacturing process thereof**
Leistungsbauelement als integrierte Struktur in MOS-Technologie und Verfahren zu seiner Herstellung
Structure intégrée de dispositif de puissance en technologie MOS et procédé pour sa fabrication

(43) Date of publication of application: 28.08.1996
(73) Proprietor: Consorzio per la Ricerca sulla Microelettronica nel Mezzogiorno, 95121 Catania (IT)
(72) Inventor: Grimaldi, Antonio, I-95030 Mascalucia (IT); Schillaci, Antonino, I-98100 Messina (IT)
(74) Representative: Mittler, Enrico

(56) References cited:
- EP-A- 0 119 400
- EP-A- 0 211 972
- EP-A- 0 279 403
- EP-A- 0 358 389
- EP-A- 0 393 949
- DE-A- 3 902 300
- US-A- 4 901 127
- US-A- 5 160 985
- PATENT ABSTRACTS OF JAPAN vol. 014 no. 387 (E-0967) ,21 August 1990 & JP-A-02 143566 (TOSHIBA CORP) 1 June 1990,

## Description

The present invention relates to a MOS-technology power device integrated structure, more particularly to a Vertical Double-Diffused power MOS (VDMOS) or an Insulated Gate Bipolar Transistor (IGBT), and to a manufacturing process thereof.

Conventional MOS-technology power devices have a cellular structure, comprising several thousands elementary cells integrated in a semiconductor substrate to form a bidimensional array; each elementary cell represents an elementary VDMOS and is connected in parallel to all the other cells, in order to contribute for a given fraction to the overall current of the power device.

MOS-technology power devices of this type are for example described in the United States Patents No. 5,008,725, No. 4,593,302 and No. 4,680,853.

Each cell comprises a polygonal P type body region (square or hexagonal) formed in a lightly doped N type layer; a polygonal source region is provided inside each body region; the polygonal source region defines a polygonal annular portion comprised between the external edge of the source region and the edge of the body region; such polygonal annular portion, covered by a thin oxide layer (gate oxide) and a polysilicon layer (polysilicon gate), forms a channel region of the elementary VDMOS.

The polysilicon gate and the underlying gate oxide form a mesh over the surface of the lightly doped N type layer, since they substantially are continuous layers with openings over the center of the elementary cells. Elongated regions with no elementary cells are provided in the gate oxide and polysilicon layers; at this elongated regions the polysilicon layer is contacted by gate metal fingers extending from a gate metal pad. The remaining surface of the chip is covered by a source metal layer contacting the source regions of all the elementary cells.

The cellular structure allows to achieve high channel lengths per unit area; this in turn limits the voltage drop across the power device when it is in the "on" state (i.e. the so-called "on-state resistance" R_{DSon}): this is an important parameter, because it is directly related to the steady-state power dissipation of the power device.

However, due to the fact that the resistivity of polysilicon is not negligible, a parasitic resistance is intrinsecally introduced by the polysilicon layer in series between the gate metal pad and the gate of the cells; the farther a cell from a gate metal finger, the higher its gate resistance. Such a resistance, together with the input capacitances of the cells and with other parasitic capacitances (e.g. the parasitic capacitances between the polysilicon gate and the substrate in the area between the cells), forms an RC circuit which strongly affects the dynamic performances of the power device.

Although the polysilicon gate layer is normally doped to reduce its resistivity, the effects on the dynamic performances of the power device are limited.

A significant improvement would be obtained augmenting the number of gate metal fingers, thus reducing the spacing between them; this obviously reduces the gate resistance of the elementary cells, but at the expense of a reduction in the channel length per unit area, and thus with an increase in the R_{DSo}n.

The parasitic capacitances can be controlled by using a thicker gate oxide: this however has an impact on the threshold voltage of the power device.

A reduction in the spacing between the cells also allows to limit the parasitic capacitances, but again at the expense of an increase in the R_{DSon}.

EP-A-393 949 discloses a power field effect device substantially as recited in the preamble of claim 1. A further prior art device is disclosed in JP-A-2 143 566.

In view of the state of the art described, it is an object of the present invention to provide a new MOS-technology power device integrated structure which overcomes the above-mentioned problems; more specifically, the new MOS-technology power device structure shall have good dynamic performances but not at the expense of the steady-state performances.

According to the present invention, such object is attained by means of a MOS power device integrated structure as set forth in claim 1.

A MOS power device structure according to the present invention has no longer a cellular structure; the "body regions" are represented by said elongated doped semiconductor stripes, and the channel is an elongated portion of said elongated stripes defined by the elongated source region. Each insulated gate stripe, which is associated with two elongated channel regions defined in the adjacent elongated stripes by the respective elongated source regions, is contacted by a respective conductive gate finger, such as a metal finger or a metal silicide finger. Thus, even if the resistivity of the insulated gate layer (polysilicon) is relatively high, the parasitic gate resistance of the power device is quite small. The dynamic performances of the power devices are thus improved, but not at the expense of the static performances.

In a preferred embodiment, a second plurality of elongated doped semiconductor stripes of the first conductivity type is also provided, these further elongated stripes being also merged with said annular region; each elongated stripe of this second plurality is located under a respective insulated gate stripe, so that the elongated stripes of the first plurality are intercalated with the elongated stripes of the second plurality.

The elongated stripes of the second plurality, being merged with the annular region, are at the same electric potential as the elongated stripes of the first plurality, i.e. at the source potential. The presence of a doped semiconductor stripe of the first conductivity type under the insulated gate layer has two major advantages. Firstly, it allows an improvement in the dynamic performances of the power device: in fact, being the stripe at the source potential, the parasitic capacitance associated to the insulated gate layer is an input capacitance (i.e. a capacitance between gate and source), while if the stripe were absent the parasitic capacitance would be between gate and drain (the semiconductor substrate). Due to the Miller effect, a capacitance between gate and drain affects more negatively the dynamic performances than an input capacitance. Secondly, the presence of the doped semiconductor stripes under the insulated gate stripes allows to flatten the electric field lines in the regions between the elongated stripes when the device is strongly reverse-biased (high reverse voltage applied between source and drain). Crowding of the electric field lines is thus avoided, so that early breakdowns at the edges of the doped semiconductor stripes are prevented; this leads to an increase in the breakdown voltage of the power device.

Preferably, heavily doped semiconductor stripes of the second conductivity type are provided between the doped semiconductor stripes of the first and second pluralities.

The presence of heavily doped stripes of the first conductivity type at the sides of the doped semiconductor stripes forming the "body regions" of the power device leads to a reduction in the R_{DSon}.

The insulated gate layer is insulated from the underlyng semiconductor layer by means of an oxide layer.

In one embodiment of the present invention, such an oxide layer has a uniform thickness, equal to the thickness of a thin gate oxide over the channel regions.

In another, preferred embodiment of the invention, such an oxide layer comprises thin gate oxide areas over the channel regions, and thicker oxide areas between the elongated stripes of the first plurality, in particular over the elongated semiconductor stripes of the second plurality.

The use of a thicker oxide layer over the regions between the "active" stripes (i.e. the elongated stripes of the first plurality, containing the source regions) reduces the parasitic capacitance between gate and source, thus improving the dynamic performances of the device. Moreover, it is advantageous from the point of view of the manufacturing yield, since it is known that thin oxide layers over heavily doped regions are quite defective.

These and other features of the present invention will be made more evident by the following detailed description of some particular embodiments, described as non-limiting examples with reference to the annexed drawings, wherein:
Figure 1 is a schematic top-plan view of a MOS-technology power device chip according to the present invention;
Figure 2 is an enlarged view of a corner region of the chip of Figure 1;
Figure 3 is an enlarged view of another region of the chip of Figure 1;
Figure 4 is a cross-sectional view taken along line IV-IV of Figure 2;
Figure 5 is a cross-sectional view taken along line V-V of Figure 2;
Figure 6 is a cross-sectional view taken along line VI-VI of Figure 2;
Figure 7 is a cross-sectional view taken along line VII-VII of Figure 2, in a first embodiment of the invention;
Figure 8 is a cross-sectional view taken along line VIII-VIII of Figure 3, in the first embodiment of the invention;
Figure 9 is similar to Figure 7, in a second, preferred embodiment of the invention;
Figure 10 is similar to Figure 8, in said preferred embodiment;
Figures 11 to 16 are cross-sectional views taken along line VII-VII of Figure 2 showing some steps of a process for the manufacturing of a MOS-technology power device according to the first embodiment of the invention;
Figures 14A is a cross-sectional view showing an alternative step to that of Figure 14 of a process for the manufacturing of a MOS-technology power device according to the preferred embodiment of the invention;
Figures 15A and 16A are cross-sectional views showing further steps of the process for the manufacturing of the device according to the preferred embodiment;
Figure 17 is a schematic top-plan view of the MOS-technology power device integrated structure after the step of Figure 14;
Figure 18 is a diagram showing doping profiles of several doped regions of the MOS-technology power device structure of the present invention;
Figure 19 is a diagram comparatively showing current-voltage characteristics for a cellular power device of the known art and for the power device of the present invention;
Figure 20 is a detailed top-plan view of a portion of a body region of the MOS-technology power device of the present invention, in one particular embodiment.

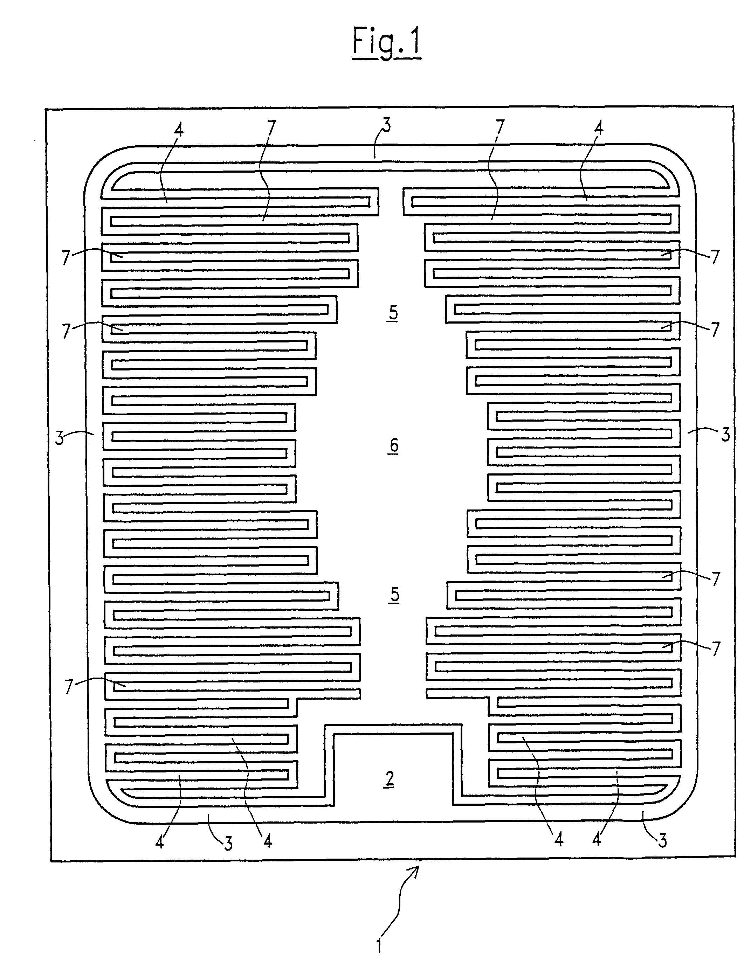

Figure 1 schematically shows in top-plan view a chip 1 of a MOS-technology power device according to the present invention. The chip 1 is provided, near its periphery, with a gate metal pad 2; a gate metal ring 3 running along the periphery of the chip 1 is connected at its edges to the gate pad 2. Conductive gate fingers 4 depart horizzontally from the gate ring 3 and extend towards the center of the chip 1.

At the center of the chip 1 a source metal plate 5 is provided; the source plate 5 has a central enlarged pad area 6; source metal fingers 7 depart horizontally from the source plate 5 towards the periphery of the chip 1 and are interdigitated with the gate fingers 4. The source metal plate 5 is rather narrow near the periphery of the chip 1 and becomes progressively wider approaching the pad area 6; this is because the source plate 5 must sustain a current which is smaller near the periphery of the chip 1 (where the current is the sum of a small number of contributions from the individual source fingers 7) and which becomes larger approaching the source pad area 6.

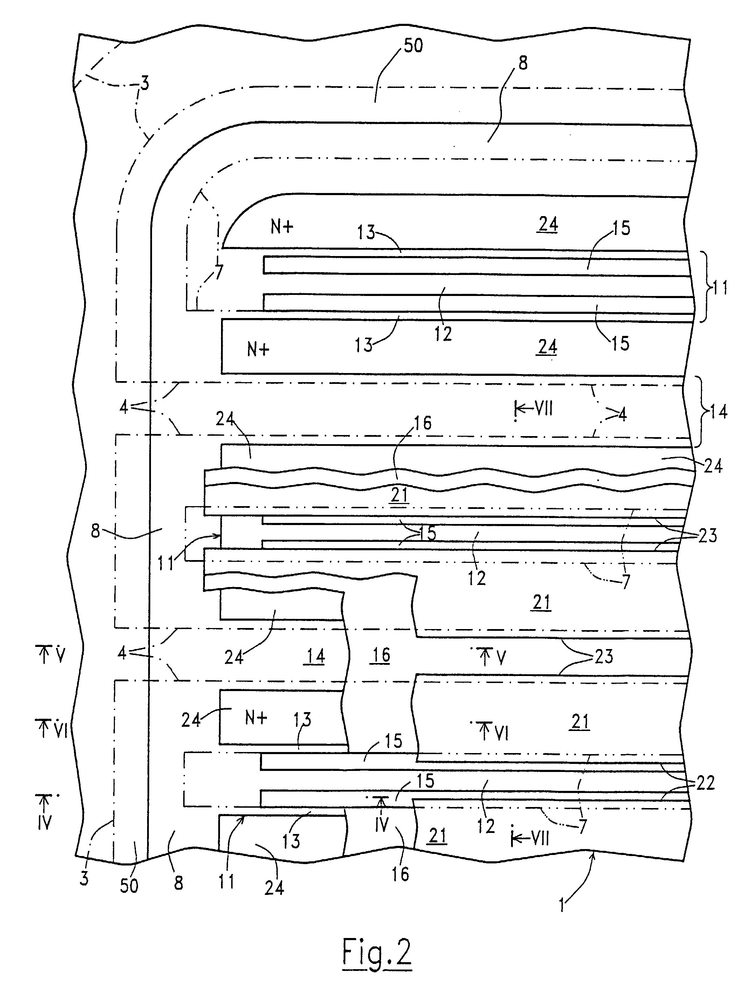

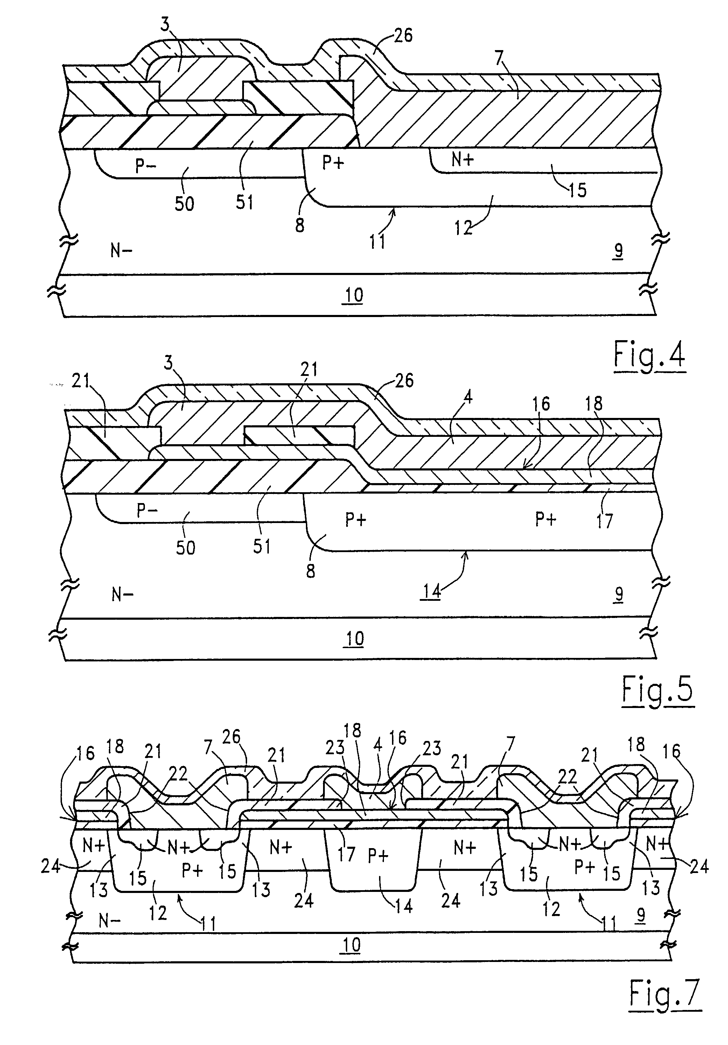

Figure 2 is an enlarged top-plan view of a corner region of the chip 1 of Figure 1, more precisely the upper-left corner; the gate ring 3, the gate fingers 4 and the source fingers 7 are shown in phantom for the sake of clarity. A P+ ring 8 concentrical with the gate metal ring 3 is visible; as shown in the cross-sectional views of Figures 4, 5 and 6, the P+ ring 8 is formed in a N- semiconductor layer 9 (typically a lightly doped epitaxial layer). The N- layer 9 is in turn superimposed on a heavily doped semiconductor substrate 10; the substrate 10 can be either of the N type, in the case of a power VDMOS, or of the P type, in the case of an Insulated Gate Bipolar Transistor (IGBT). All the conductivity types given above relates to N-channel devices; for P-channel devices all the conductivity types must be reversed. A P- ring 50 is provided all around the P+ ring 8 (Figs. 2 and 4-6); the P- ring 50 forms in a per-se known way an edge structure for the P+ ring 8, and spreads the depletion region associated to the junction between the P+ ring 8 and the N- layer 9, thus increasing the breakdown voltage of the power device.

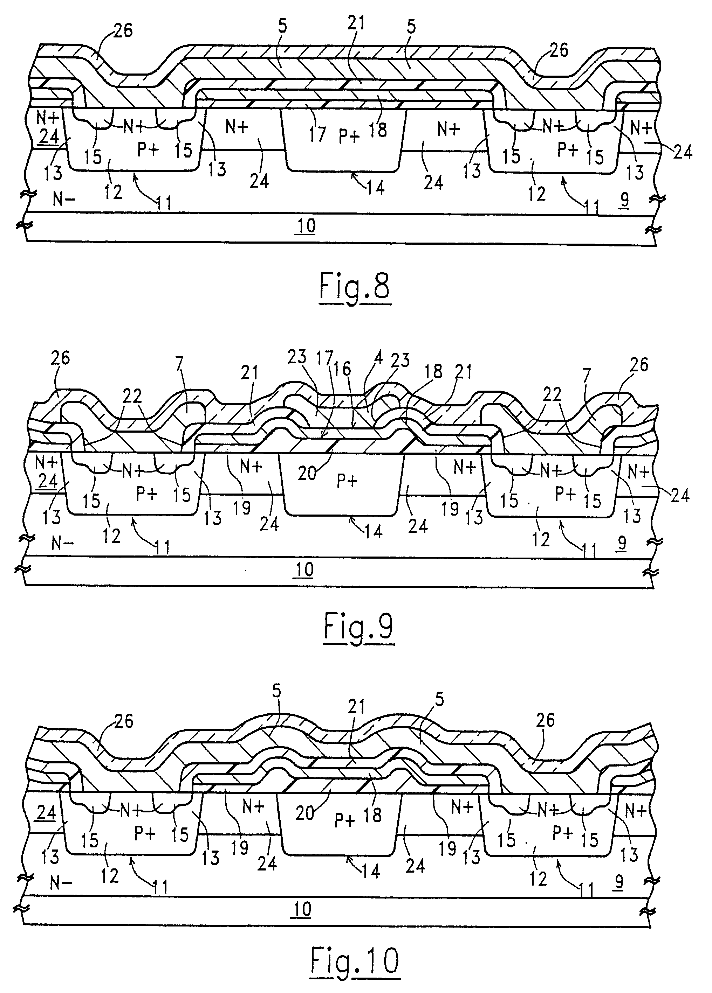

As visible in Figures 2 and 4, a first plurality of P type stripes 11 departs horizontally from the P+ ring 8. The stripes 11 forms so-called "body regions" of the power device; as better visible in Figure 7 (which is a cross-section in a direction transversal to the stripes 11), each stripe 11 comprises a central P+ portion 12 (analogous to the so-called "deep body region" of the cellular devices of the known art) and two shallower and more lightly doped portions 13 at the sides of and merged with the P+ portion 12. Also, inside each stripe 11 two N+ source stripes 15 are provided; the N+ source stripes 15 substantially extends for the whole length of the stripe 11 (see Figure 4). In alternative, the N+ source stripes 15 can be provided with periodic interruptions (Fig. 20), for the reasons which will be explained later on.

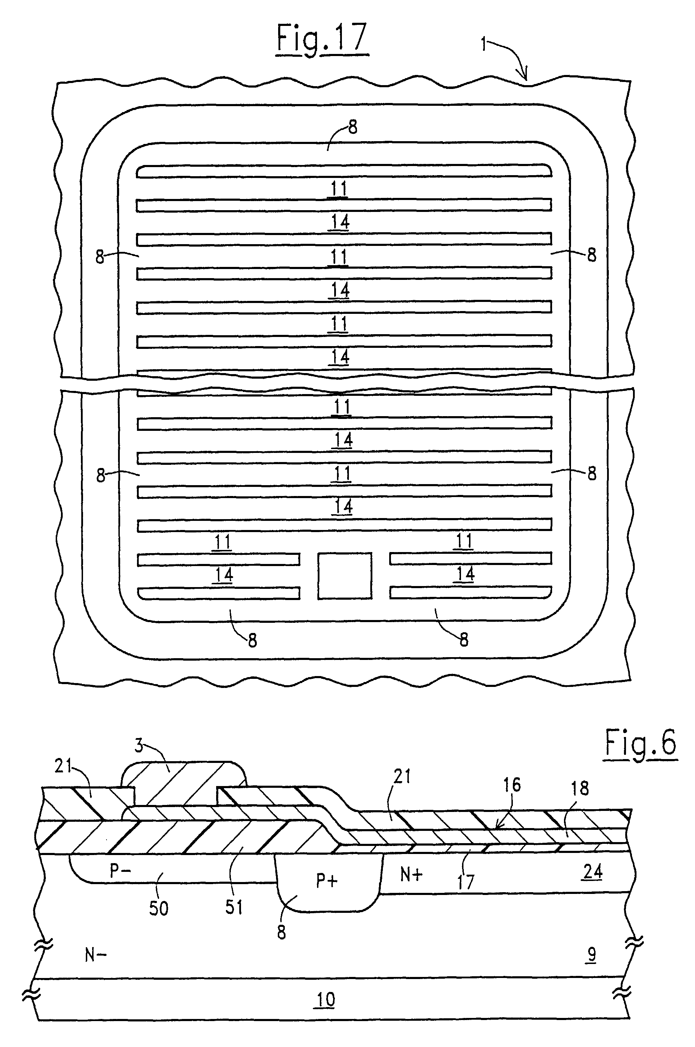

As also shown in Figures 2 and 5, a second plurality of P+ stripes 14 also departs horizontally from the P+ ring 8. The stripes 14 of the second plurality are intercalated with the stripes 11 of the first plurality, i.e. between two stripes 11 there is always provided a stripe 14.

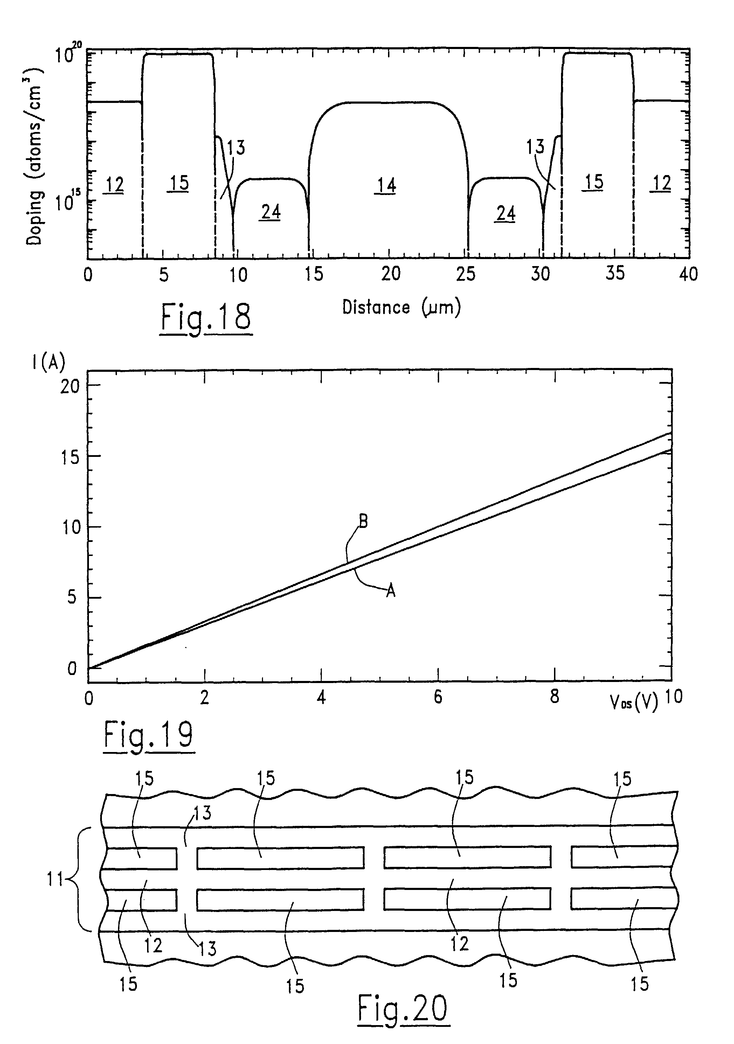

As shematically shown in Figure 17, both the stripes 11 and the stripes 14 extend horizontally for substantially the whole length of the chip 1, and are merged at both their edges with the P+ ring 8; only in a chip region under the gate metal pad 2 the stripes 11 and 14 do not extend for the whole length of the chip, but they are however merged at both sides with the P+ ring 8.

As shown in Figures 2 and 6, N+ stripes 24 extend horizontally between the stripes 11 and 14. The stripes 24 are completely isolated one from the other, being surrounded at each side by P type regions.

As shown in Figure 2, stripes 16 of a conductive insulated gate layer are placed over the P+ stripes 14; each stripe 16 partially extends over the lightly doped portions 13 of two adjacent stripes 11.

As shown in Figure 7, the insulated gate layer comprises an oxide layer 17 and a polysilicon gate layer 18. In one embodiment of the invention, the oxide layer 17 is rather thin and has a uniform thickness. In a preferred embodiment of the invention, shown in Figure 9, the oxide layer 17 comprises thin gate oxide portions 19 which extend over the lightly doped portions 13 of the stripes 11, and thicker portions 20 over the P+ stripes 14. As previously noted, the use of a thicker oxide layer over the P+ stripes 14 reduces the parasitic capacitance between the polysilicon gate layer 18 and the P+ stripes 14, i.e. the gate-source (input) parasitic capacitance, thus improving the dynamic performances of the device. Also, it is advantageous from the point of view of the manufacturing yield, since it is known that heavily doped semiconductor regions such as the P+ stripes 14 getter metal contaminants, and when a thin oxide layer is formed over such heavily doped regions these contaminants migrate in the oxide layer inducing defects.

A dielectric layer 21 is placed over the insulated gate stripes 16; elongated windows 22 and 23 are provided in the dielectric layer 21 respectively over the center of the stripes 11 and over the center of the stripes 14. Each source metal finger 7, placed over the dielectric layer 21, contacts the N+ source stripes 15 and the P+ portion 12 of a respective stripe 11; each gate finger 4, also placed over the dielectric layer 21, contacts a respective underlying stripe 16 of insulated gate layer. the gate fingers 4 can be made of metal, exactly as the source fingers 7, or they can be made of a silicide. In the case the N+ source stripes 15 are provided with periodic interruptions, as shown in Figure 20, a better short-circuit of the whole P+ portion 12 (including the part of the P+ portion 12 under the N+ source stripes 15) with the N+ source stripes 15 is achieved; this assures that the parasitic bipolar transistor with emitter, base and collector represented by the regions 15, 12 and 9 has the base short-circuited with the emitter.

The P- ring 50 which surrounds the P+ ring 8 is covered by a thick field oxide layer 51; the polysilicon layer 18 extends over the field oxide layer 26, where it is contacted by the gate ring 3.

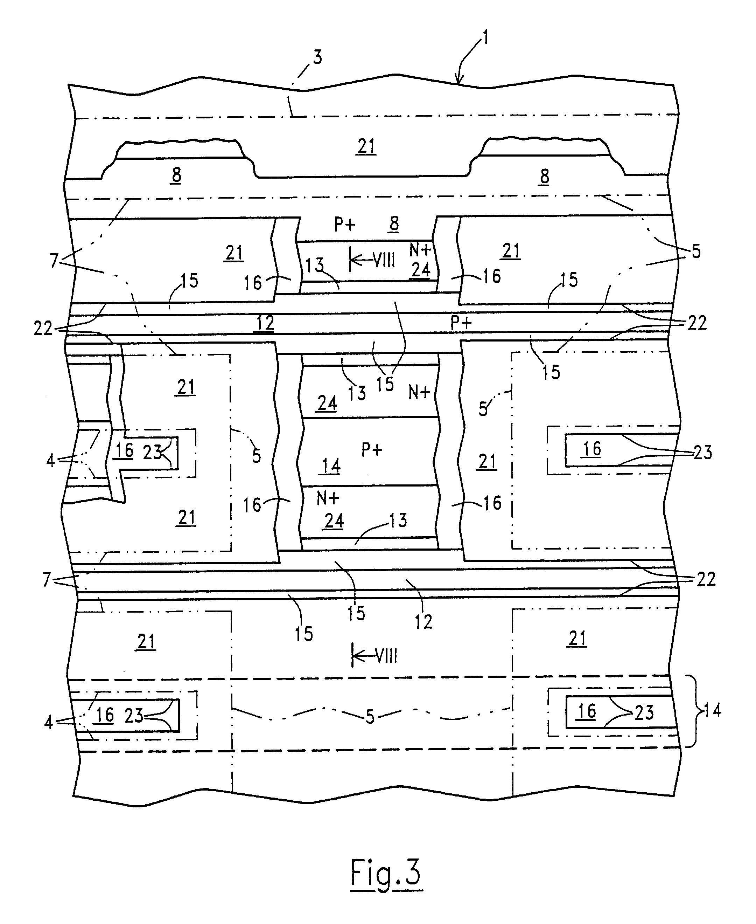

As shown in Figure 3, which is an enlarged view of upper-central portion of the chip of Figure 1, the windows 22 in the dielectric layer 21 extends horizontally for substantially the whole length of the chip 1; thus, at the center of the chip 1 the P+ portion 12 and the N+ source stripes 15 of each stripe 11 can be contacted by the source metal plate 5. The windows 23 instead do not extend for the whole length of the chip, being interrupted at the center of the chip 1 near the source plate 5, to prevent the source plate 5 to come into contact with the insulated gate layer 16. This clearly appears from Figures 8 and 10, which similarly to Figures 7 and 9 respectively illustrates the two possible embodiments of the invention with respect to the structure of the oxide layer 17.

The whole chip is covered by a passivating layer 26, in which windows are opened over the gate metal pad 2 and the pad area 6 of the source metal plate 5.

The presence of the P+ stripes 14 under the insulated gate layer 16 between adjacent "body region" stripes 11 has two major advantages. Firstly, it allows an improvement in the dynamic performances of the power device: in fact, being the P+ stripes 14 at the source potential (because they are merged with the P+ ring 8), the parasitic capacitance associated to the insulated gate layer 16 is an input capacitance, i.e. a capacitance between gate and source, while if the stripe were absent the parasitic capacitance associated to the insulated gate layer 16 would be a capacitance between the polysilicon gate 18 and the N- layer 9, i.e. a gate-drain capacitance. Due to the Miller effect, a gate-drain capacitance affects more negatively the dynamic performances than an input capacitance. Secondly, the P+ stripes 14 allow to flatten the electric field lines in the regions of the N- layer 9 between the stripes 11 when the device is strongly reverse-biased (high reverse voltage applied between source and drain). Crowding of the electric field lines is thus avoided, so that early breakdowns at the edges of the doped semiconductor stripes are prevented; this leads to an increase in the breakdown voltage. Experimental tests have proven that breakdown voltages of up to 40 V are attainable.

The presence of the N+ stripes 24 allows a reduction in the "on resistance" R_{DSon} of the power device.

It has been experimentally proven that a MOS-technology power device integrated structure according to the present invention shows a gate resistance (R_{g}) varying between 0.7 and 1 Ohm, while a cellular structure device according to the known art shows typical gate resistance values ranging from 2.2 and 3.1 Ohms; thus, the gate resistance of the power device structure of the present invention is significantly lower than that of known power devices, and is less dispersed. Such a reduction in the gate resistance has not been achieved at the expenses of the on-state resistance R_{DSon}: experimental tests, shown in Figure 19, have proven that the power device structure of the present invention has a lower R_{DSon} than known cellular power devices. In Figure 19, which is a source current vs drain-source voltage plot, curve A refers to a cellular power device according to the known art, and curve B refers to a power device according to the present invention: it appears that for any drain-source voltage value, the source current sunk by the power device according to the invention is higher than that of the cellular power device. It should be appreciated that such improvements have been obtained only by means of a different layout technique, and not in the manufacturing technology.

A manufacturing process for a MOS-technology power device according to the present invention starts with a heavily doped semiconductor substrate 10. A lightly doped layer 9 is epitaxially grown over the substrate 10; the lightly doped layer 9 is of the N type for an N-channel device, and of the P type for a P-channel device.

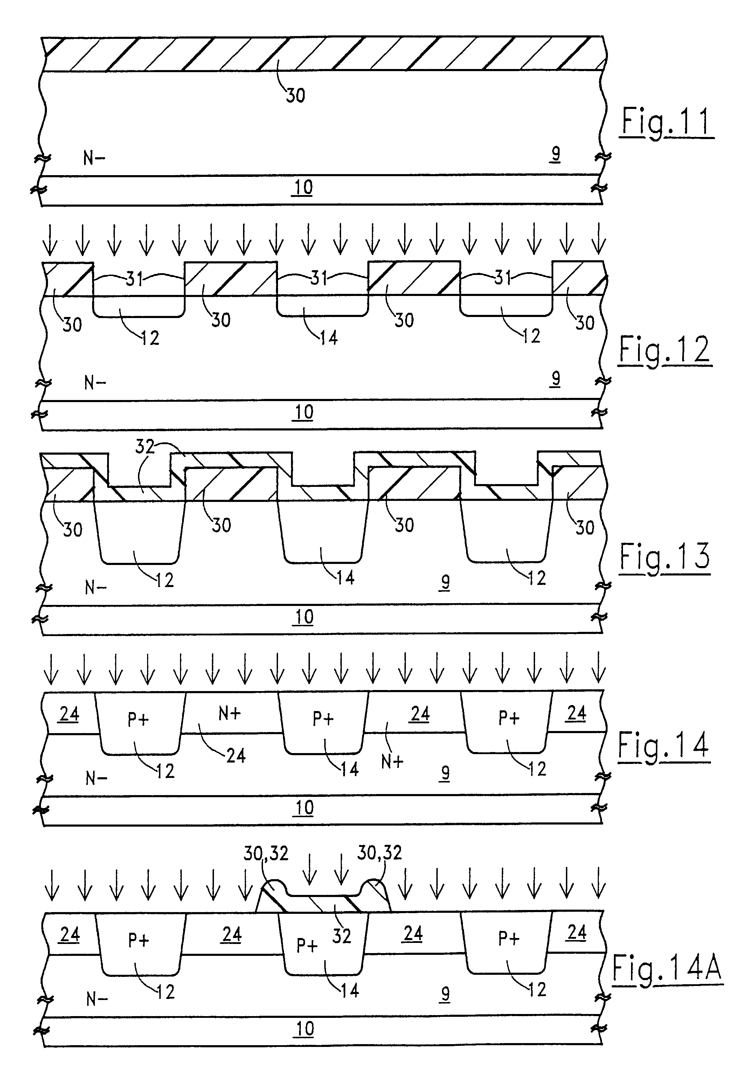

A thick field oxide layer 30 is formed over the N- layer 9 (Fig. 11). The field oxide layer 30 is then selectively removed to open in it windows 31 for the implantation of a P type dopant, to form the P+ ring 8, the P+ portions 12 of the stripes 11 and the P+ stripes 14. The implant dose is between 10¹⁵-10¹⁶ atoms/cm² (Fig. 12). After this implantation, the filed oxide layer 30 is again selectively removed, and a P type dopant is implanted in a dose of about 10¹² atoms/cm² to form the P- ring 50.

A thermal diffusion process is then performed submitting the chip to a temperature of about 1100-1200 °C for two-three hours, to make the implanted dopant diffuse. Successively, the chip is submitted to a temperature of about 1000 °C for five-six hours: an oxide layer 32 about 13000 Angstroms thick grows over the whole surface of the chip 1 (Fig. 13).

The oxide layers 32 and 30 are then completely removed except that near the edges of the chip (over the P- ring 50, see Figures 4-6), and an N type dopant is implanted to form the N+ stripes 24; the implantation dose, of the order of 10¹² atoms/cm², is sufficiently low not to reverse the conductivity type of the already formed regions 12 and 14. After the implantation, an annealing treatment is performed (Fig. 14).

A thin gate oxide layer 17 is then formed over the surface of the chip; the oxide layer 17 has a typical thickness of about 1000 Angstroms.

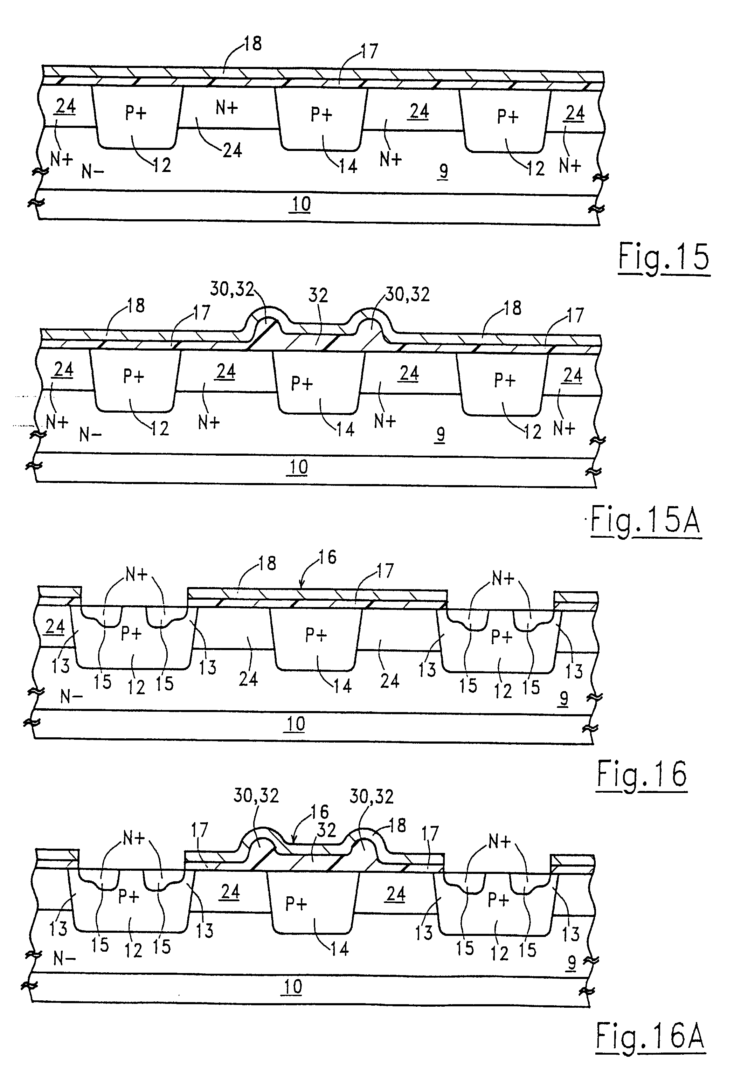

A polysilicon layer 18 is deposited over the gate oxide layer 17 (Fig. 15).

The polysilicon layer 18 and the oxide layer 17 are then selectively removed over the stripes 12 to define the insulated gate stripes 16.

A P type dopant is then implanted in a dose of about 10¹³ atoms/cm² and is then made to diffuse by means of thermal process at a temperature of about 1100 °C for six-seven hours to form the lightly doped portions 13 of the stripes 11 at the sides of the P+ portions 12 (Fig. 16).

An N type dopant is then selectively implanted in the stripes 11 to form the N+ source stripes 15; the N type dopant dose is of the order of 10¹⁵ atoms/cm². A short thermal diffusion process allows the diffusion of the N type dopant to form the source stripes 15.

A dielectric layer 21 is then deposited over the whole chip, and it is then selectively removed to open the contact windows 22 and 23.

A metal layer is deposited over the dielectric layer 21, and it is selectively removed to define the gate pad 2, the gate ring 3, the gate fingers 4, the source plate 5 and the source fingers 7.

Figure 18 shows the doping profile of the different doped semiconductor regions at the end of the manufacturing process.

Figure 14A show an alternative process step suitable to obtain a structure according to the preferred embodiment of the invention.

Coming back to Figure 13, the oxide layers 32 and 30 are not removed from the regions over the P+ stripes 14: in this way, as shown in Figure 14A, the 13000 Angstroms-thick oxide layer 32 is left over the P+ stripes 14.

The process goes on in the same way previously described; Figures 15A and 16A show the structure according to the preferred embodiment of the invention after the steps 15 and 16 of the process previously described.

It will be appreciated by those skilled in the art that the present invention not only applies discrete power devices, as those previously described, but also to MOS-technology power devices integrated in Vertical Intelligent Power ("VIP") integrated circuits and BCD integrated circuits.

## Claims

1. MOS power device integrated structure comprising a first plurality of elongated doped semiconductor stripes (11) of a first conductivity type formed in a semiconductor layer (9) of a second conductivity type, each of said elongated stripes (11) including an elongated source region (15) of the second conductivity type, insulated gate stripes (16) extending over the semiconductor layer (9) between adjacent elongated stripes (11), a source metal plate (5) electrically connected to source regions (15), and a gate pad (2) electrically connected to the insulated gate stripes (16), characterized in that:
an annular doped semiconductor region (8) of the first conductivity type is provided in the semiconductor layer (9) so as to surround and being merged with said elongated stripes (11);
the source metal plate is located substantially at the center of the integrated structure;
a plurality of source metal fingers (7) is provided, each source metal finger (7) extending from the source metal plate (5) over a respective elongated stripes (11) and contacting the respective elongated stripe (11) and the elongated source region (15) included therein;
a conductive gate ring (3) is provided which is connected to the gate pad (2);
a plurality of conductive gate fingers (4) is provided, each conductive gate finger (4) extending from the conductive gate ring (3) over a respective insulated gate stripe (16) and connected thereto,
so that the source metal fingers (7) and the conductive gate fingers (4) are interdigitated.

2. MOS power device integrated structure according to claim 1, characterized in that it comprises a second plurality of elongated doped semiconductor stripes (14) of the first conductivity type, merged with said annular region (8), each elongated stripe (14) of the second plurality being located under a respective insulated gate stripe (16), so that the elongated stripes (11) of the first plurality are intercalated by the elongated stripes (14) of the second plurality.

3. MOS power device integrated structure according to claim 2, characterized in that it comprises heavily doped semiconductor stripes (24) of the second conductivity type between the elongated stripes (11,14) of the first and second pluralities.

4. MOS power device integrated structure according to anyone of the preceding claims, characterized in that the insulated gate stripes (16) are insulated from the underlyng semiconductor layer (9) by means of an oxide layer (17).

5. MOS power device integrated structure according to claim 4, characterized in that said oxide layer (17) is a thin gate oxide layer and has a uniform thickness.

6. MOS power device integrated structure according to claim 4, characterized in that said oxide layer (17) comprises thick field oxide areas (20) over the semiconductor layer (9) between the elongated stripes (11) of the first plurality, and thin gate oxide areas (19) partially extending over the elongated stripes (11) of the first plurality.

7. MOS power device integrated structure according to anyone of the preceding claims, characterized in that said elongated source region (15) comprises two laterally displaced elongated source regions (15).

8. MOS power device integrated structure according to claim 7, characterized in that said two laterally displaced elongated source regions (15) substantially extends for the whole length of the respective elongated stripe (11) of the first plurality in which they are included.

9. MOS power device integrated structure according to claim 7, characterized in that said two laterally displaced elongated source regions (15) are provided with periodic interruptions.

10. MOS power device integrated structure according to anyone of the preceding claims, characterized in that each elongated stripe (11) of the first plurality comprises a heavily doped elongated central portion (12) and two lateral lightly doped elongated lateral portions (13).

11. MOS power device integrated structure according to anyone of the preceding claims, characterized in that said elongated stripes (14) of the second plurality and said annular region (8) are heavily doped.

12. MOS power device integrated structure according to anyone of the preceding claims, characterized in that said semiconductor layer (9) is lightly doped.

13. MOS power device integrated structure according to anyone of the preceding claims, characterized in that said semiconductor layer (9) lies over a heavily doped semiconductor substrate (10).

14. MOS power device integrated structure according to claim 13, characterized in that said semiconductor substrate (10) is of the second conductivity type.

15. MOS power device integrated structure according to claim 13, characterized in that said semiconductor substrate (10) is of the first conductivity type.

16. MOS power device integrated structure according to anyone of the preceding claims, characterized in that said first and second conductivity types are the P and N types, respectively.

17. MOS power device integrated structure according to anyone of claims 1-15, characterized in that said first and second conductivity types are the N and P types, respectively.

18. Process for the manufacturing of a MOS power device integrated structure according to any of the previous claims, said process comprising the steps of providing for forming a first plurality of elongated doped semiconductor stripes (11) of a first conductivity type and an annular doped semiconductor region (8) of the first conductivity type in a lightly doped semiconductor layer (9) of a second conductivity type, the annular region (8) surrounding and being merged with the elongated stripes (11), forming elongated source regions (15) of the second conductivity type in said elongated stripes (11), forming conductive insulated gate stripes (16) over the semiconductor layer (9) between and partially extending over said elongated stripes (11), forming conductive gate fingers (4) extending over and contacting respective insulated gate stripes (16), forming a conductive gate ring (3) surrounding the gate fingers (4), forming source metal fingers (7) each one extending over and contacting a respective elongated stripe (11) and the elongated source region (15) formed therein, the source metal fingers extending from a common source metal pate (5) located substantially at the center of the integrated structure.

19. Process according to claim 18, characterized by further providing for forming a second plurality of elongated doped semiconductor stripes (14), inside and merged with said annular region (8), each one intercalated with the elongated stripes (11) of the first plurality.

20. Process according to claim 19, characterized by providing for forming heavily doped semiconductor stripes (24) of the second conductivity type between the elongated stripes (11,14) of the first and second pluralities.

21. Process according to claim 20, characterized by the following steps:
a) forming a thick oxide layer (30) over the lightly doped semiconductor layer (9);
b) selectively removing the thick oxide layer (30) to open windows (31);
c) implanting a heavy dose of a first dopant of the first conductivity type through the windows (31) in the thick oxide layer (30);
d) diffusing the first dopant to form said first and second pluralities of elongated stripes (11,14) and said annular region (8);
e) removing the thick oxide layer (30);
f) implanting a second dopant of the second conductivity type to form said heavily doped stripes (24) of the second conductivity type, said second dopant being implanted in a dose suitable not to invert the conductivity type of the elongated stripes (11,14) and of the annular region (8);
g) forming a thin gate oxide layer (17);
forming a polysilicon layer (18) over the gate oxide layer (17);
h) selectively removing the polysilicon layer (18) and the gate oxide layer (17) to define said insulated gate stripes (16);
i) implanting a low dose of a third dopant of the first conductivity type to form lightly doped elongated channel portions (13) at the sides of the elongated stripes (11) of the first plurality;
l) selectively implanting a heavy dose of a fourth dopant of the second conductivity type to form said elongated source regions (15);
m) forming a dielectric layer (21);
selectively removing the dielectric layer (21) to open elongated contact windows (22,23) respectively over the elongated stripes (11) of the first conductivity type and the insulated gate stripes (16);
n) forming a metal layer over the dielectric layer (21);
o) selectively removing the metal layer to form said source fingers (7) and gate fingers (4).

22. Process according to claim 21, characterized in that in step d) it provides for growing a further thick oxide layer (32), and in that in step e) the thick oxide layers (30,32) are not removed over the elongated stripes (14) of the second plurality.

## Patentansprüche

1. MOS-Leistungsvorrichtung mit integrierter Struktur, die eine erste Vielzahl verlängerter dotierter Halbleiterstreifen (11) eines ersten Leitfähigkeitstyps aufweist, die in einer Halbleiterschicht (9) eines zweiten Leitfähigkeitstyps ausgebildet sind, wobei jeder der verlängerten Streifen (11) ein verlängertes Source-Gebiet (15) des zweiten Leitfähigkeitstyps enthält, wobei sich Gate-lsolierstreifen (16) über der Halbleiterschicht (9) zwischen benachbarten verlängerten Streifen (11) erstrecken, eine Source-Metallplatte (5), die elektrisch mit Source-Gebieten (15) verbunden ist, und einen Gate-Anschlußflecken (2), der mit den Gate-lsolierstreifen (16) elektrisch verbunden ist, dadurch gekennzeichnet, daß
ein ringförmiges dotiertes Halbleitergebiet (8) des ersten Leitfähigkeitstyps in der Halbleiterschicht (9) derart vorgesehen ist, daß es die verlängerten Streifen (11) umgibt und daß es mit den verlängerten Streifen (11) vereinigt ist;
die Source-Metallplatte im wesentlichen in der Mitte der integrierten Struktur angeordnet ist;
eine Vielzahl von Source-Metallfingern (7) vorgesehen ist, wobei jeder Source-Metallfinger (7) sich von der Source-Metallplatte (5) über einen jeweiligen verlängerten Streifen (11) erstreckt und den jeweiligen verlängerten Streifen (11) und das darin enthaltene verlängerte Source-Gebiet (15) kontaktiert;
ein leitender Gate-Ring (3) vorgesehen ist, der mit dem Gate-Anschlußflecken (2) verbunden ist;
eine Vielzahl leitender Gate-Finger (4) vorgesehen ist, wobei sich jeder leitende Gate-Finger (4) vom leitenden Gate-Ring (3) über einen jeweiligen Gate-lsolierstreifen (16) erstreckt und mit ihm verbunden ist,
so daß die Source-Metallfinger (7) und die leitenden Gate-Finger (4) ineinandergreifen.

2. MOS-Leistungsvorrichtung mit integrierter Struktur nach Anspruch 1, dadurch gekennzeichnet, daß sie eine zweite Vielzahl verlängerter dotierter Halbleiterstreifen (14) des ersten Leitfähigkeitstyps aufweist, die mit dem ringförmigen Gebiet (8) vereinigt sind, wobei jeder verlängerte Streifen (14) der zweiten Vielzahl unter einem jeweiligen Gate-lsolierstreifen (16) angeordnet ist, so daß die verlängerten Streifen (11) der ersten Vielzahl mit dem dazwischen geschobenen verlängerten Streifen (14) der zweiten Vielzahl angeordnet sind.

3. MOS-Leistungsvorrichtung mit integrierter Struktur nach Anspruch 2, dadurch gekennzeichnet, daß sie stark dotierte Halbleiterstreifen (24) des zweiten Leitfähigkeitstyps zwischen den verlängerten Streifen (11, 14) der ersten Vielzahl und der zweiten Vielzahl aufweist.

4. MOS-Leistungsvorrichtung mit integrierter Struktur nach einem der vorangehenden Ansprüche, dadurch gekennzeichnet, daß die Gate-lsolierstreifen (16) von der darunterliegenden Halbleiterschicht (9) mittels einer Oxidschicht (17) isoliert sind.

5. MOS-Leistungsvorrichtung mit integrierter Struktur nach Anspruch 4, dadurch gekennzeichnet, daß die Oxidschicht (17) eine dünne Gate-Oxidschicht ist und eine einheitliche Dicke hat.

6. MOS-Leistungsvorrichtung mit integrierter Struktur nach Anspruch 4, dadurch gekennzeichnet, daß die Oxidschicht (17) dicke Feldoxidbereiche (20) über der Halbleiterschicht (9) zwischen den verlängerten Streifen (11) der ersten Vielzahl aufweist, und dünne Gate-Oxidbereiche (19), die sich teilweise über den verlängerten Streifen (11) der ersten Vielzahl erstrecken.

7. MOS-Leistungsvorrichtung mit integrierter Struktur nach einem der vorangehenden Ansprüche, dadurch gekennzeichnet, daß das verlängerte Source-Gebiet (15) zwei lateral verlängerte Source-Gebiete (15) aufweist.

8. MOS-Leistungsvorrichtung mit integrierter Struktur nach Anspruch 7, dadurch gekennzeichnet, daß sich die zwei lateral versetzten verlängerten Source-Gebiete (15) im wesentlichen über die gesamte Länge des jeweiligen verlängerten Streifens (11) der ersten Vielzahl erstrecken, in dem sie enthalten sind.

9. MOS-Leistungsvorrichtung mit integrierter Struktur nach Anspruch 7, dadurch gekennzeichnet, daß die zwei lateral versetzten verlängerten Source-Gebiete (15) mit periodischen Unterbrechungen vorgesehen sind.

10. MOS-Leistungsvorrichtung mit integrierter Struktur nach einem der vorangehenden Ansprüche, dadurch gekennzeichnet, daß jeder verlängerte Streifen (11) der ersten Vielzahl einen stark dotierten verlängerten zentralen Abschnitt (12) und zwei laterale leicht dotierte verlängerte laterale Abschnitte (13) aufweist.

11. MOS-Leistungsvorrichtung mit integrierter Struktur nach einem der vorangehenden Ansprüche, dadurch gekennzeichnet, daß die verlängerten Streifen (14) der zweiten Vielzahl und das ringförmige Gebiet (8) stark dotiert sind.

12. MOS-Leistungsvorrichtung mit integrierter Struktur nach einem der vorangehenden Ansprüche, dadurch gekennzeichnet, daß die Halbleiterschicht (9) leicht dotiert ist.

13. MOS-Leistungsvorrichtung mit integrierter Struktur nach einem der vorangehenden Ansprüche, dadurch gekennzeichnet, daß die Halbleiterschicht (9) über einem stark dotierten Halbleitersubstrat (10) liegt.

14. MOS-Leistungsvorrichtung mit integrierter Struktur nach Anspruch 13, dadurch gekennzeichnet, daß das Halbleitersubstrat (10) vom zweiten Leiffähigkeitstyp ist.

15. MOS-Leistungsvorrichtung mit integrierter Struktur nach Anspruch 13, dadurch gekennzeichnet, daß das Halbleitersubstrat (10) vom ersten Leiffähigkeitstyp ist.

16. MOS-Leistungsvorrichtung mit integrierter Struktur nach einem der vorangehenden Ansprüche, dadurch gekennzeichnet, daß der erste und der zweite Leiffähigkeitstyp jeweils der P- und der N-Typ ist.

17. MOS-Leistungsvorrichtung mit integrierter Struktur nach einem der Ansprüche 1 bis 15, dadurch gekennzeichnet, daß der erste und der zweite Leiffähigkeitstyp jeweils der N- und der P-Typ ist.

18. Verfahren zum Herstellen einer MOS-Leistungsvorrichtung mit integrierter Struktur nach einem der vorangehenden Ansprüche, wobei das Verfahren folgende Schritte aufweist: Ausbilden einer ersten Vielzahl verlängerter dotierter Halbleiterstreifen (11) eines ersten Leitfähigkeitstyps und eines ringförmigen dotierten Halbleitergebiets (8) des ersten Leitfähigkeitstyps in einer leicht dotierten Halbleiterschicht (9) eines zweiten Leitfähigkeitstyps, wobei das ringförmige Gebiet (8) die verlängerten Streifen (11) umgibt und mit ihnen vereinigt ist; Ausbilden verlängerter Source-Gebiete (15) des zweiten Leitfähigkeitstyps in den verlängerten Streifen (11); Ausbilden leitender Gate-lsolierstreifen (16) über der Halbleiterschicht (9) zwischen den verlängerten Streifen (11) und sich teilweise über diese erstreckend; Ausbilden leitender Gate-Finger (4), die sich über jeweilige Gate-lsolierstreifen (16) erstrecken und diese kontaktieren; Ausbilden eines leitenden Gate-Rings (3), der die Gate-Finger (4) umgibt; Ausbilden von Source-Metallfingern (7), wobei sich jeder über einen jeweiligen verlängerten Streifen (11) und das darin ausgebildete verlängerte Source-Gebiet (15) erstreckt und dieses kontaktiert, wobei sich die Source-Metallfinger von einer gemeinsamen Source-Metallplatte (5) erstrecken, die im wesentlichen in der Mitte der integrierten Struktur angeordnet ist.

19. Verfahren nach Anspruch 18, dadurch gekennzeichnet, daß es weiterhin zum Ausbilden einer zweiten Vielzahl verlängerter dotierter Halbleiterstreifen (14) vorgesehen ist, die innerhalb des ringförmigen Gebiets (8) sind und mit diesem vereinigt sind, wobei jeder zwischen den verlängerten Streifen (11) der ersten Vielzahl eingeschoben angeordnet ist.

20. Verfahren nach Anspruch 19, dadurch gekennzeichnet, daß es weiterhin zum Ausbilden stark dotierter Halbleiterstreifen (24) des zweiten Leitfähigkeitstyps zwischen den verlängerten Streifen (11, 14) der ersten Vielzahl und der zweiten Vielzahl vorgesehen ist.

21. Verfahren nach Anspruch 20, das durch folgende Schritte gekennzeichnet ist:
a) Ausbilden einer dicken Oxidschicht (30) über der leicht dotierten Halbleiterschicht (9);
b) selektives Entfernen der dicken Oxidschicht (30), um Fenster (31) zu öffnen;
c) Implantieren einer starken Dosis eines ersten Dotierungsmittels des ersten Leiffähigkeitstyps durch die Fenster (31) in der dicken Oxidschicht (30);
d) Diffundieren des ersten Dotierungsmittels, um die erste Vielzahl und die zweite Vielzahl verlängerter Streifen (11, 14) und das ringförmige Gebiet (8) auszubilden;
e) Entfernen der dicken Oxidschicht (30);
f) Implantieren des zweiten Dotierungsmittels des zweiten Leitfähigkeitstyps, um die stark dotierten Streifen (24) des zweiten Leitfähigkeitstyps auszubilden, wobei das zweite Dotierungsmittel in einer Dosis implantiert wird, die dazu geeignet ist, den Leiffähigkeitstyp der verlängerten Streifen (11, 14) und des ringförmigen Gebiets (8) nicht zu invertieren;
g) Ausbilden einer dünnen Gate-Oxidschicht (17);
Ausbilden einer Polysiliziumschicht (18) über der Gate-Oxidschicht (17);
h) selektives Entfernen der Polysiliziumschicht (18) und der Gate-Oxidschicht (17), um die Gate-lsolierstreifen (16) zu definieren;
i) Implantieren einer niedrigen Dosis eines dritten Dotierungsmittels des ersten Leitfähigkeitstyps, um leicht dotierte verlängerte Kanalabschnitte (13) an den Seiten der verlängerten Streifen (11) der ersten Vielzahl auszubilden;
l) selektives Implantieren einer starken Dosis eines vierten Dotierungsmittels des zweiten Leitfähigkeitstyps, um die verlängerten Source-Gebiete (15) auszubilden;
m) Ausbilden einer dielektrischen Schicht (21);
selektives Entfernen der dielektrischen Schicht (21), um verlängerte Kontaktfenster (22, 23) zu öffnen, die jeweils über den verlängerten Streifen (11) des ersten Leitfähigkeitstyps und den Gate-lsolierstreifen (16) sind;
n) Ausbilden einer Metallschicht über der dielektrischen Schicht (21);
o) selektives Entfernen der Metallschicht, um die Source-Finger (7) und die Gate-Finger (4) auszubilden.

22. Verfahren nach Anspruch 21, dadurch gekennzeichnet, daß im Schritt d) ein Aufwachsen einer weiteren dicken Oxidschicht (32) vorgeshen ist, und dadurch, daß im Schritt e) die dicken Oxidschichten (30, 32) über den verlängerten Streifen (14) der zweiten Vielzahl nicht entfernt werden.

## Revendications

1. Structure intégrée de dispositif de puissance métal-oxyde-semiconducteur (MOS) comprenant une première pluralité de bandes allongées (11) de semiconducteur dopé d'un premier type de conductivité, aménagées dans une couche semiconductrice (9) d'un second type de conductivité, chacune desdites bandes allongées (11) comportant une région de source allongée (15) du second type de conductivité, des. bandes de grille isolées (16) s'étendant sur la couche semiconductrice (9) entre des bandes allongées (11) adjacentes, une plaque métallique de source (5) en connexion électrique avec les régions de source (15), et un contact de grille (2) en connexion électrique avec les bandes de grille isolées (16), caractérisée en ce que :
une région annulaire (8) de semiconducteur dopé du premier type de conductivité est prévue dans la couche semiconductrice (9) afin d'être reliée auxdites bandes allongées (11) et de les entourer;
la plaque métallique de source est située sensiblement au centre de la structure intégrée;
une pluralité de doigts métalliques de source (7) est prévue, chaque doigt métallique de source (7) s'étendant sur une bande allongée (11) respective depuis la plaque métallique de source (5) et établissant un contact avec la bande allongée (11) respective et la région de source allongée (15) qui y est incluse;
un anneau de grille conducteur (3) est prévu, relié au contact de grille (2);
une pluralité de doigts de grille conducteurs (4) est prévue, chaque doigt de grille conducteur (4) s'étendant, depuis l'anneau de grille conducteur (3), sur une bande de grille isolée (16) respective et connecté à celle-ci,
de sorte que les doigts métalliques de source (7) et les doigts de grille conducteurs (4) sont interdigités.

2. Structure intégrée de dispositif de puissance métal-oxyde-semiconducteur (MOS) selon la revendication 1, caractérisée en ce qu'elle comprend une seconde pluralité de bandes allongées (14) de semiconducteur dopé du premier type de conductivité, reliée à ladite région annulaire (8), chaque bande allongée (14) de la seconde pluralité étant située sous une bande de grille isolée (16) respective, de sorte que les bandes allongées (11) de la première pluralité sont intercalées avec les bandes allongées (14) de la seconde pluralité.

3. Structure intégrée de dispositif de puissance métal-oxyde-semiconducteur (MOS) selon la revendication 2, caractérisée en ce qu'elle comprend des bandes semiconductrices fortement dopées (24) du second type de conductivité entre les bandes allongées (11, 14) des. première et seconde pluralités.

4. Structure intégrée de dispositif de puissance métal-oxyde-semiconducteur (MOS) selon l'une quelconque des revendications précédentes, caractérisée en ce que les bandes de grille isolées (16) sont isolées de la couche semiconductrice (9) sous-jacente au moyen d'une couche d'oxyde (17).

5. Structure intégrée de dispositif de puissance métal-oxyde-semiconducteur (MOS) selon la revendication 4, caractérisée en ce que ladite couche d'oxyde (17) est une mince couche d'oxyde de grille et a une épaisseur uniforme.

6. Structure intégrée de dispositif de puissance métal-oxyde-semiconducteur (MOS) selon la revendication 4, caractérisée en ce que ladite couche d'oxyde (17) comprend des zones épaisses d'oxyde de champ (20) sur la couche semiconductrice (9) entre les bandes allongées (11) de la première pluralité, et des zones minces d'oxyde de grille (19) s'étendant partiellement sur les bandes allongées (11) de la première pluralité.

7. Structure intégrée de dispositif de puissance métal-oxyde-semiconducteur (MOS) selon l'une quelconque des revendications précédentes, caractérisée en ce que ladite région de source allongée (15) comprend deux régions de source allongées (15) déplacées latéralement.

8. Structure intégrée de dispositif de puissance métal-oxyde-semiconducteur (MOS) selon la revendication 7, caractérisée en ce que lesdites deux régions de source allongées (15) déplacées latéralement s'étendent sensiblement sur toute la longueur de la bande allongée (11) respective de la première pluralité dans laquelle elle sont incluses.

9. Structure intégrée de dispositif de puissance métal-oxyde-semiconducteur (MOS) selon la revendication 7, caractérisée en ce que lesdites deux régions de source allongées (15) déplacées latéralement sont pourvues d'interruptions périodiques.

10. Structure intégrée de dispositif de puissance métal-oxyde-semiconducteur (MOS) selon l'une quelconque des revendications précédentes, caractérisée en ce que chaque bande allongée (11) de la première pluralité comprend une longue partie centrale fortement dopée (12) et deux longues parties latérales légèrement dopées (13).

11. Structure intégrée de dispositif de puissance métal-oxyde-semiconducteur (MOS) selon l'une quelconque des revendications précédentes, caractérisée en ce que lesdites bandes allongées (14) de la seconde pluralité et ladite région annulaire (8) sont fortement dopées.

12. Structure intégrée de dispositif de puissance métal-oxyde-semiconducteur (MOS) selon l'une quelconque des revendications précédentes, caractérisée en ce que ladite couche semiconductrice (9) est légèrement dopée.

13. Structure intégrée de dispositif de puissance métal-oxyde-semiconducteur (MOS) selon l'une quelconque des revendications précédentes, caractérisée en ce que ladite couche semiconductrice (9) repose sur un substrat semiconducteur fortement dopé (10).

14. Structure intégrée de dispositif de puissance métal-oxyde-semiconducteur (MOS) selon la revendication 13, caractérisée en ce que ledit substrat semiconducteur (10) est du second type de conductivité.

15. Structure intégrée de dispositif de puissance métal-oxyde-semiconducteur (MOS) selon la revendication 13, caractérisée en ce que ledit substrat semiconducteur (10) est du premier type de conductivité.

16. Structure intégrée de dispositif de puissance métal-oxyde-semiconducteur (MOS) selon l'une quelconque des revendications précédentes, caractérisée en ce que lesdits premier et second types de conductivité sont les types P et N, respectivement.

17. Structure intégrée de dispositif de puissance métal-oxyde-semiconducteur (MOS) selon l'une quelconque des revendications 1 à 15, caractérisée en ce que lesdits premier et second types de conductivité sont les types N et P, respectivement.

18. Procédé pour la fabrication d'une structure intégrée de dispositif de puissance métal-oxyde-semiconducteur (MOS) selon l'une quelconque des revendications précédentes, ledit procédé comprenant les étapes consistant à former une première pluralité de bandes allongées (11) de semiconducteur dopé d'un premier type de conductivité et une région annulaire (8) de semiconducteur dopé du premier type de conductivité dans une couche semiconductrice (9) légèrement dopée d'un second type de conductivité, la région annulaire (8) étant reliée aux bandes allongées (11) en les entourant, former des régions de source allongées (15) du second type de conductivité dans lesdites bandes allongées (11), former des bandes de grille conductrices isolées (16) sur la couche semiconductrice (9) entre lesdites bandes allongées (11) et recouvrant partiellement celles-ci, former des doigts de grille conducteurs (4) s'étendant sur les bandes de grille isolées (16) respectives et établissant un contact avec elles, former un anneau de grille conducteur (3) entourant les doigts de grille (4), former des doigts métalliques de source (7), chacun s'étendant sur une bande allongée (11) respective et établissant un contact avec elle et la région de source allongée (15) qui y est formée, les doigts métalliques de source s'étendant depuis une plaque métallique de source (5) commune située sensiblement au centre de la structure intégrée.

19. Procédé selon la revendication 18, caractérisé en ce qu'il comprend de plus l'étape consistant à former une seconde pluralité de bandes allongées (14) de semiconducteur dopé, à l'intérieur de ladite région annulaire (8) et reliée à celle-ci, chacune de ces bandes étant intercalée avec les bandes allongées (11) de la première pluralité.

20. Procédé selon la revendication 19, caractérisé en ce qu'il comprend l'étape consistant à former des bandes semiconductrices fortement dopées (24) du second type de conductivité entre les bandes allongées (11, 14) des première et seconde pluralités.

21. Procédé selon la revendication 20, caractérisé par les étapes consistant à :
a) former une couche épaisse d'oxyde (30) sur la couche semiconductrice (9) légèrement dopée;
b) retirer de manière sélective la couche épaisse d'oxyde (30) pour ouvrir des fenêtres (31);
c) implanter une forte dose d'un premier dopant du premier type de conductivité dans la couche épaisse d'oxyde (30) par les fenêtres (31);
d) diffuser le premier dopant pour former lesdites première et seconde pluralités de bandes allongées (11, 14) et ladite région annulaire (8);
e) retirer la couche épaisse d'oxyde (30);
f) implanter un deuxième dopant du second type de conductivité pour former lesdites bandes fortement dopées (24) du second type de conductivité, ledit deuxième dopant étant implanté à une dose appropriée pour ne pas inverser le type de conductivité des bandes allongées (11, 14) et de la région annulaire (8);
g) former une mince couche d'oxyde de grille (17);
former une couche de silicium polycristallin (18) sur la couche d'oxyde de grille (17);
h) retirer de manière sélective la couche de silicium polycristallin (18) et la couche d'oxyde de grille (17) pour définir lesdites bandes de grille isolées (16);
i) implanter une faible dose d'un troisième dopant du premier type de conductivité pour former de longues parties de canal légèrement dopées (13) sur les côtés des bandes allongées (11) de la première pluralité;
l) implanter de manière sélective une forte dose d'un quatrième dopant du second type de conductivité pour former lesdites régions de source allongées (15);
m) former une couche diélectrique (21);
retirer de manière sélective la couche diélectrique (21) pour ouvrir des fenêtres de contact allongées (22, 23) respectivement sur les bandes allongées (11) du premier type de conductivité et sur les bandes de grille isolées (16);
n) former une couche métallique sur la couche diélectrique (21);
o) retirer de manière sélective la couche métallique pour former lesdits doigts de source (7) et doigts de grille (4).

22. Procédé selon la revendication 21, caractérisé en ce que l'étape d) comprend la croissance d'une couche épaisse d'oxyde (32) supplémentaire, et en ce que dans l'étape e) les couches épaisses d'oxyde (30, 32) ne sont pas retirées au-dessus des bandes allongées (14) de la seconde pluralité.
